# EUROPÄISCHE PATENTSCHRIFT

(11) **EP 0 512 365 B1**
(45) Veröffentlichungstag und Bekanntmachung des Hinweises auf die Patenterteilung: **31.07.1996**
(21) Anmeldenummer: 92107211.2
(22) Anmeldetag: 28.04.1992
(51) Int. Cl.: H03G 9/00

(54) **Vorrichtung zur gehörrichtigen Lautstärkesteuerung**
Apparatus for aurally compensated volume regulation
Dispositif pour régulation de volume à correction auditive

(30) Priorität: 02.05.1991 DE 4114364
(43) Veröffentlichungstag der Anmeldung: 11.11.1992
(73) Patentinhaber: SGS-THOMSON MICROELECTRONICS GMBH, D-85630 Grasbrunn (DE)
(72) Erfinder: Kirchlechner, Peter, W-8201 Hohenthann (DE)
(74) Vertreter: Klunker . Schmitt-Nilson . Hirsch

(56) Entgegenhaltungen:
- DD-A- 229 557
- DE-B- 2 250 725
- US-A- 4 363 934

## Beschreibung

Die Erfindung betrifft eine Vorrichtung zur gehörrichtigen Lautstärkesteuerung gemäß Oberbegriff des Anspruchs 1.

Geräte, mit denen Audiosignale hörbar gemacht werden, haben üblicherweise eine Vorrichtung zur Lautstärkesteuerung. Das Lautstärkeempfinden des menschlichen Ohres ist jedoch frequenzabhängig. Bei kleinem Schalldruck werden tiefe Frequenzen weniger laut empfunden als hohe Frequenzen. Dies kann man in einer subjektiven Empfindungsstärkeskala darstellen, wofür teilweise auch der aus dem englischsprachigen Raum übernommene Begriff Loudness verwendet wird. Vorliegend wird hierfür der Begriff gehörrichtige Lautstärke verwendet.

Bei höherwertigen Audiogeräten, beispielsweise Stereoanlagen oder Stereoautoradios, wird diese subjektive Empfindungsstärkeskala berücksichtigt, indem eine physiologisch angepaßte Lautstärkesteuerung vorgenommen wird.

Eine herkömmliche physiologisch angepaßte, also gehörrichtige Lautstärkesteuerung, die in dem Buch PHONO TECHNIK von P. Zastrow, Frankfurter Fachverlag, 1984, Seiten 141-144, gezeigt ist und von der im Anspruch 1 ausgegangen wird, verwendet für die Lautstärkesteuerung ein Potentiometer, das zwischen eine Audiosignalquelle und Masse geschaltet ist. Das Potentiometer weist einen verschiebbaren Abgriff und einen feststehenden Abgriff auf. Von dem verschiebbaren Abgriff wird das gedämpfte Audiosignal abgenommen. Zwischen den feststehenden Abgriff und Masse ist ein Kondensator geschaltet, welcher der Berücksichtigung des Gehörempfindens dient. Mit zunehmender Frequenz des Audiosignals wird die zwischen dem feststehenden Abgriff und Masse befindliche Widerstandsstrecke des Potentiometers immer stärker von dem Kondensator überbrückt. Auf diese Weise werden bei gleichbleibender Stellung des verschiebbaren Abgriffs niedrige Frequenzen des Audiosignals weniger stark gedämpft als hohe Frequenzen des Audiosignals, also gegenüber hohen Frequenzen angehoben.

Ein weiteres Beispiel für eine gehörnichtige Lautstärkesteuerung findet sich in DE-A-2 250 725.

In Audiogeräten der genannten Art setzt sich die Digitalisierung immer stärker durch. Gewünscht sind Vorrichtungen, die eine digitale Lautstärkesteuerung eines analogen Audiosignals ermöglichen.

Der Erfindung liegt daher die Aufgabe zugrunde, eine Vorrichtung zur digitalen gehörrichtigen Lautstärkesteuerung analoger Audiosignale verfügbar zu machen.

Eine Lösung dieser Aufgabe besteht in einer Vorrichtung der eingangs angegebenen Art, die dadurch gekennzeichnet ist, daß die Widerstandsteilereinrichtung zur digitalen Steuerbarkeit der Vorrichtung mindestens zwei feinstufige und eine grobstufige Widerstandskette aufweist, wobei jedem Widerstand je ein Abgriffsanschluß zugeordnet ist, daß den Abgriffsanschlüssen jeder Widerstandskette eine Abgriffsauswahleinrichtung zugeordnet ist, die mittels eines von der gewünschten Lautstärke abhängenden Abgriffsauswahlsignals steuerbar ist, daß die beiden feinstufigen Widerstandsketten zu einer Reihenschaltung zusammengeschaltet sind, die einen Endes mit dem zu dämpfenden Audiosignal und anderen Endes mit dem Bezugspotential beaufschlagbar ist, daß der Verbindungspunkt zwischen den beiden Widerstandsketten mit der Korrekturimpedanz verbunden ist, daß die grobstufige Widerstandskette einen Endes mit derjenigen Abgriffsauswahleinrichtung verbunden ist, welche der mit dem zu dämpfenden Audiosignal beaufschlagbaren feinstufigen Widerstandskette zugeordnet ist, und anderen Endes mit dem Bezugspotential beaufschlagbar ist, daß von der der grobstufigen Widerstandskette zugeordneten Abgriffsauswahleinrichtung das gedämpfte Audiosignal abnehmbar ist und daß zwischen diejenige Abgriffsauswahleinrichtung, welche der mit dem Bezugspotential beaufschlagten feinstufigen Widerstandskette zugeordnet ist, und mindestens einen Einspeisungsanschluß an einer vorbestimmten Stelle längs der grobstufigen Widerstandskette eine Einspeisungseinrichtung zur Einspeisung eines die Gehörempfindungscharakteristik berücksichtigenden Korrektursignals in die grobstufige Widerstandskette geschaltet ist.

Mit einer derartigen Vorrichtung läßt sich auf technisch einfache Weise eine physiologisch angepaßte Lautstärkesteuerung eines analogen Audiosignals auf digitalem Weg durchführen.

Eine derartige Vorrichtung ist vorzugsweise als integrierte Halbleiterschaltung oder in einer integrierten Halbleiterschaltung ausgebildet, wobei lediglich die Korrekturimpedanz durch ein externes Bauelement oder mehrere externe Bauelemente gebildet wird.

Vorzugsweise ist die Korrekturimpedanz durch einen Korrekturkondensator verwirklicht. Die Korrekturimpedanz kann beispielsweise auch durch ein Impedanznetzwerk gebildet werden.

Vorteilhafte Ausgestaltungen und Weiterbildungen der erfindungsgemäßen Vorrichtung sind in den Unteransprüchen angegeben.

Die Erfindung wird nun anhand einer Ausführungsform näher erläutert. In den Zeichnungen zeigen:
- Fig. 1: eine herkömmliche Vorrichtung zur gehörrichtigen Lautstärkesteuerung mit einem Potentiometer;
- Fig. 2: eine digital gesteuerte Vorrichtung zur Lautstärkesteuerung ohne Berücksichtigung der Gehörempfindungscharakteristik;
- Fig. 3: eine bevorzugte Ausführungsform einer erfindungsgemäßen Vorrichtung zur digitalen gehörrichtigen Lautstärkesteuerung;
- Fig. 4: eine Darstellung der korrigierten Lautstärke in Abhängigkeit der Frequenz des Audiosignals für unterschiedlich stark gedämpfte Audiosignale; und
- Fig. 5: eine Darstellung eines Beispiels einer gehörrichtigen Korrektur in Abhängigkeit der Lautstärkedämpfung bei einer erfindungsgemäßen Vorrichtung.

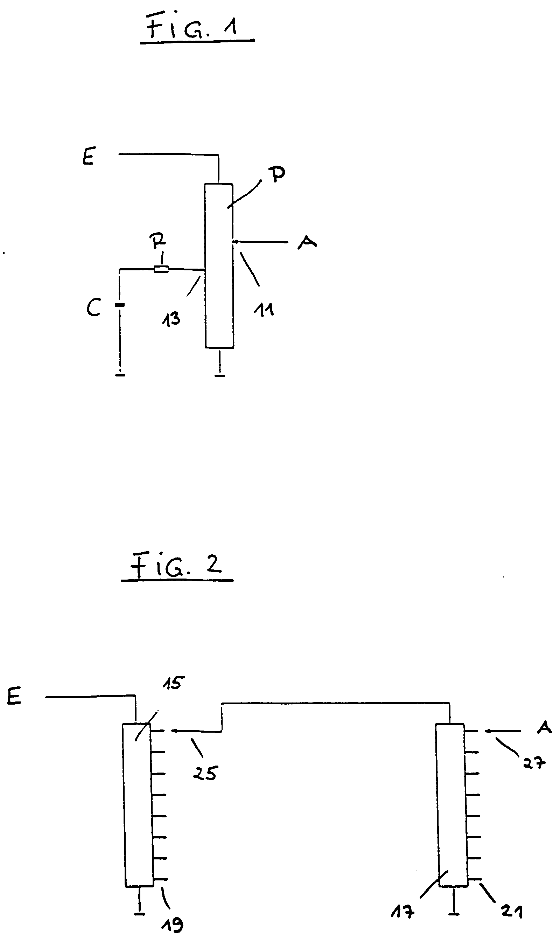

Fig. 1 zeigt eine herkömmliche Potentiometerlösung mit einem Potentiometer P, das zwischen einen Signaleingang E und Masse geschaltet ist. Ein verschiebbarer Abgriff 11 des Potentiometers P ist mit einem Signalausgang A verbunden. Ein feststehender Abgriff 13 des Potentiometers P ist über eine Reihenschaltung aus einem Widerstand R und einem Kondensator C mit Masse verbunden.

Zur Einstellung der gewünschten Lautstärke eines über den Signaleingang E zugeführten Audiosignals wird der verschiebbare Abgriff 11 in die gewünschte Abgriffsstellung gebracht. Das Audiosignal wird entsprechend der zwischen dem Signaleingang E und dem verschiebbaren Abgriff 11 liegenden Widerstandsstrecke des Potentiometers P mehr oder weniger gedämpft.

Die gehörrichtige, also physiologisch angepaßte Lautstärkesteuerung wird durch den Kondensator C bewirkt. Mit zunehmender Frequenz des zu dämpfenden Audiosignals wird die zwischen dem feststehenden Abgriff 13 und Masse des Potentiometers P befindliche Widerstandsstrecke zunehmend überbrückt. Bei auf hohe Dämpfung eingestelltem Abgriff 11 werden daher niedrigere Frequenzen weniger stark gedämpft als hohe Frequenzen. Es kommt somit zu der gehörrichtigen Anhebung tiefer Frequenzen im Spektrum des zu dämpfenden Audiosignals.

Elektromechanische Komponenten wie Potentiometer versucht man in modernen Gerätelösungen zu vermeiden. Sie stellen anfällige, voluminöse und relativ teure Bauelemente dar. Außerdem eignen sie sich nicht zur digitalen Steuerung, wie sie zunehmend zum Einsatz kommt.

Ein Beispiel einer Vorrichtung zur digitalen Lautstärkesteuerung eines analogen Audiosignals ist in Fig. 2 dargestellt. Es sind zwei Däpfungsglieder in Form einer feinstufigen Widerstandskette 15 und einer grobstufigen Widerstandskette 17 vorgesehen. Jedem Widerstand einer jeden Widerstandskette 15, 17 ist ein Abgriffsanschluß zugeordnet. Bei dem dargestellten Beispiel weist jede der beiden Widerstandsketten 15 und 17 je acht Abgriffsanschlüsse 19 bzw. 21 auf. Für die feinstufige Widerstandskette 15 betragen die Dämpfungsstufen zwischen benachbarten Abgriffsanschlüssen 19 beispielsweise 1,25 dB. Bei diesem Beispiel betragen die Dämpfungsschritte zwischen benachbarten Abriffsanschlüssen 21 der grobstufigen Widerstandskette 10 dB. Die feinstufige Widerstandskette 15 ist einen Endes mit einem Signaleingang A und anderen Endes mit Masse verbunden. Die grobstufige Widerstandskette 17 wird einen Endes mit dem von der feinstufigen Widerstandskette 15 abgenommenen fein gedämpften Audiosignal beaufschlagt und ist anderen Endes mit Masse verbunden. Von einem Signalausgang A wird das von der grobstufigen Widerstandskette 17 zusätzlich gedämpfte Audiosignal abgenommen.

Die Darstellung in Fig. 2 ist sehr schematisch. Vereinfachend sind ein Abgriffspfeil 25 für die feinstufige Widerstandskette 15 und ein Abgriffspfeil 27 für die grobstufige Widerstandskette 17 dargestellt. Bei einer praktischen Ausführung sind die einzelnen Abgriffsanschlüsse 19 und 21 je über einen steuerbaren elektronischen Schalter mit einer gemeinsamen Leitung verbunden, die dem Abgriffspfeil 25 bzw. dem Abgriffspfeil 27 entspricht. Dabei werden je nach gewünschter Lautstärke, also je nach erforderlicher Dämpfung des Audiosignals, je einer der den Abgriffsanschlüssen 19 zugeordneten elektronischen Schalter und einer der den Abgriffsanschlüssen 21 zugeordneten elektronischen Schalter leitend geschaltet. Die Auswahl der leitend geschalteten Schalter geschieht bei der in Fig. 2 dargestellten Ausführungsform mit Hilfe von 6-Bit-Codewörtern, von denen drei Bit die Auswahl auf der Seite der feinstufigen Widerstandskette 15 und die restlichen drei Bits die Auswahl auf der Seite der grobstufigen Widerstandskette 17 bewirken.

Bei der in Fig 2 gezeigten Vorrichtung zur digitalen Lautstärkesteuerung läßt sich das Prinzip der gehörrichtigen Lautstärkesteuerung, wie es in Fig. 1 gezeigt ist, nicht verwirklichen.

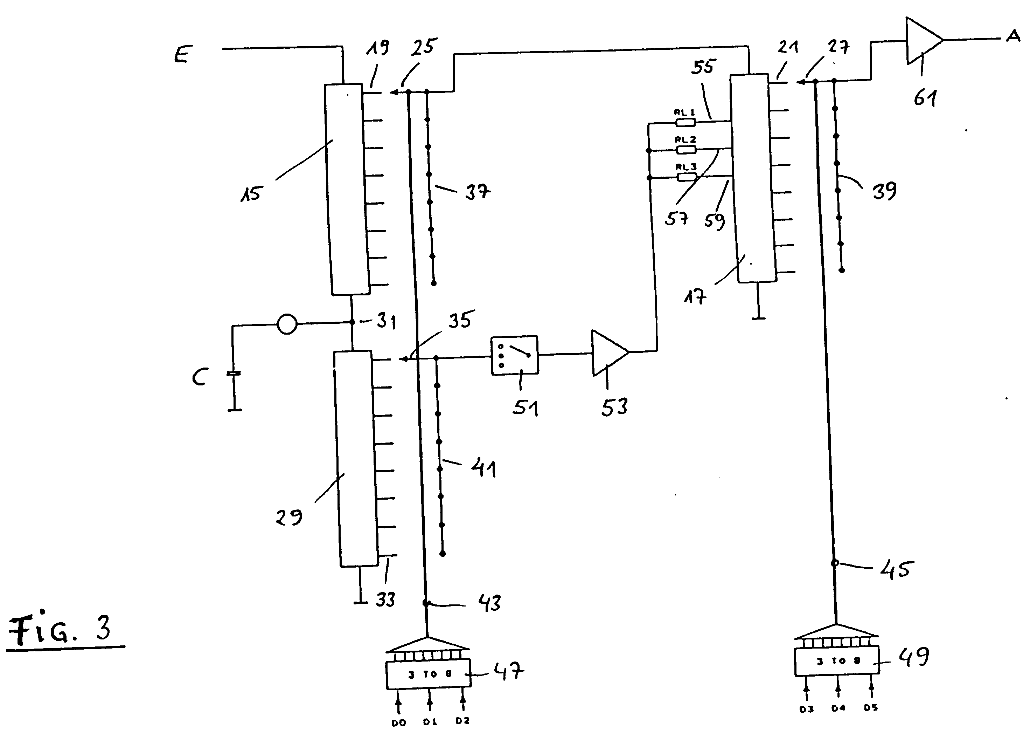

Eine Vorrichtung zur gehörrichtigen digitalen Lautstärkesteuerung analoger Audiosignale zeigt Fig. 3. Diese Ausführungsform weist alle Komponenten der in Fig. 2 gezeigten Lautstärkesteuerungsvorrichtung auf und hierfür werden in Fig. 3 die gleichen Bezugszeichen verwendet. Im Gegensatz zu Fig. 2 ist in Fig. 3 das dem Signaleingang E entgegengesetzte Ende der feinstufigen Widerstandskette 15 jedoch nicht direkt mit Masse verbunden, sondern über eine zweite feinstufige Widerstandskette 29, die mit der ersten feinstufigen Widerstandskette 15 eine Reihenschaltung bildet. Die beiden feinstufigen Widerstandsketten 15 und 29 sind in einem Verbindungspunkt 31 miteinander verbunden. Zwischen den Verbindungspunkt 31 und Masse ist ein das Gehörempfinden berücksichtigender Kondensator C geschaltet.

Die zweite feingestufte Widerstandskette 29 weist bei dem dargestellten Beispiel ebenfalls acht Abgriffsanschlüsse 33 auf. Denen ist bei der schematischen Darstellung in Fig. 3 ein Abgriffspfeil 35 zugeordnet, der wieder eine symbolische Darstellung für acht elektronische Schalter darstellt, die je einem der Abgriffsanschlüsse 33 zugeordnet sind und von denen immer einer in Abhängigkeit von der gewünschten Lautstärkedämpfung leitend schaltbar ist. Den einzelnen Abgriffspfeilen 25, 27 und 35 ist je eine Reihe von von acht Schaltersymbolen 37 bzw. 39 bzw. 41 in Form von Punkten auf je einer senkrechten Linie zugeordnet. Jeder dieser Punkte soll das eine Anschlußende eines nicht dargestellten, mit dem je gegenüberliegenden Abgriffsanschluß 19 bzw. 21 bzw. 33 verbundenen elektronischen Schalters, vorzugsweise Schalttransistors, sein.

Zu den Abgriffspfeilen 25 und 35 führt ein Bündel 43 von im vorliegenden Beispiel acht Schaltersteuerleitungen. Zu dem Abgriffspfeil 27 führt ein Bündel 45 von gleich viel Schaltersteuerleitungen. Die beiden Steuerleitungsbündel 43 und 45 sind mit je einem Decodierer 47 bzw. 49 verbunden, der aus je einem 3-Bit-Teilwort D0D1D2 bzw. D3D4D5 ein Schalterauswahlsignal auf eine ausgewählte von acht Schaltersteuerleitungen schickt. Die beiden 3-Bit-Teilwörter stammen vo einem 6-Bit-Wort, das die gewünschte Lautstärke in digital codierter Weise wiedergibt und beispielsweise in einem Schieberegister mit den Bit-Ausgängen D0 bis D5 gespeichert ist.

Die beiden feinstufigen Widerstandsketten 15 und 29 werden entsprechend dem Schalterauswahlsignal von dem zugehörigen Decodierer 47 synchron und gleichwertig abgegriffen. D.h., wenn beispielsweise der dritte Abgriffsanschluß 19 von oben der feinstufigen Widerstandskette 15 durch Leitendschalten des zugehörigen Schalttransistors abgegriffen wird, wird gleichzeitig der dritte Abgriffsanschluß 33 von oben der feinstufigen Widerstandskette 29 durch Leitendschalten des zugehörigen Schalttransistors abgegriffen.

Dem Abgriffspfeil 35 ist eine Einspeisungseinrichtung nachgeschaltet, die in Reihenschaltung ein Dämpfungsglied 51, einen Puffer 53 und drei parallel geschaltete Widerstände RL1, RL2 und RL3 aufweist. Diese Widerstände sind einen Endes gemeinsam mit dem Ausgang des Puffers 53 verbunden. Ihre je anderen Enden sind mit je einem Einspeisungsanschluß 55 bzw. 57 bzw. 59 der grobstufigen Widerstandskette 17 verbunden.

Je nach der gewählten Lautstärke wird ein entsprechend fein gedämpftes Audiosignal von der ersten feinstufigen Widerstandskette 15 abgegriffen und dem einen Ende der grobstufigen Widerstandskette 17 zugeführt. Gleichzeitig wird ein fein gedämpftes Audiosignal von dem entsprechenden Abgriffsanschluß der zweiten feinstufigen Widerstandskette 29 abgenommen und über das Dämpfungsglied 51, den Puffer 53 und die parallelen Widerstände RL1 bis RL3 auf die drei Einspeisungsanschlüsse 55 bzw. 57 bzw. 59 der grobstufigen Widerstandskette 17 gegeben. Auf diese Weise werden in die grobstufige Widerstandskette 17 zusätzlich zu dem über den Abgriffspfeil 25 gelieferten Audiosignalanteil noch weitere Audiosignalanteile über die Einspeisungsanschlüsse 55, 57 und 59 eingespeist. Da mit zunehmender Frequenz des Audiosignals der über der zweiten feinstufigen Widerstandskette 29 anstehende Anteil des Audiosignals immer geringer wird, ist mit zunehmender Frequenz auch die Einspeisung des zusätzlichen Audiosignalanteils über die Einspeisungsanschlüsse 55, 57 und 59 immer geringer. D.h., bei der in Fig. 3 dargestellten Vorrichtung werden tiefe Frequenzen im Spektrum des zu dämpfenden Audiosignals gegenüber den höherfrequenten Signalanteilen angehoben.

Der Abgriffspfeil 27 der grobstufigen Widerstandskette 17 ist über einen zweiten Puffer 61 mit dem Signalausgang A verbunden.

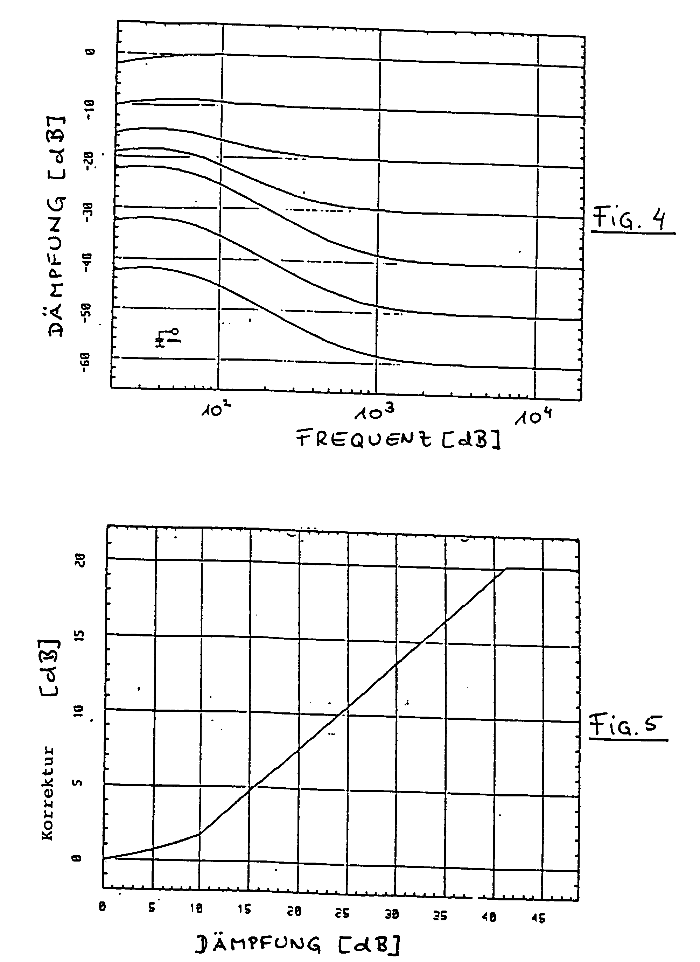

Die Wirkung der in Fig. 3 gezeigten erfindungsgemäßen Vorrichtung wird nun noch weiter anhand der Fig. 4 und 5 erläutert.

Fig. 4 zeigt eine Darstellung der Lautheit in Anhängigkeit von der Frequenz, mit unterschiedlich starken Lautstärkedämpfungswerten als Parameter. Man sieht, daß die Dämpfung für niederfrequente Signalanteile wesentlich geringer ist als für hochfrequenzte Signalanteile. Die Darstellung in Fig. 4 zeigt außerdem, daß die Anhebung der niederfrequenten Signalanteile gegenüber den hochfrequenten Signalanteilen umso stärker ist, je stärker die Lautstärkedämpfung ist, je leiser also das hörbar gemachte Audiosignal ist.

Fig. 5 zeigt eine Charakteristik für die Anhebung von niedrigen Tonfrequenzen (Baßfrequenzen) in Abhängigkeit von der Lautstärkedämpfung. Die einzelnen Kennlinienteile der Fig. 5 werden durch die Widerstandswerte der Widerstände RL1 bis RL3 und durch die Position der Einspeisungsanschlüsse 55, 57, 59 entlang der grobstufigen Widerstandskette 17 realisiert. Das Dämpfungsglied 51 dient dazu, die Quantisierungsstufen zu glätten, die dadurch zustande kommen, daß es sich bei den Widerstandsketten 15, 17 und 29 nicht um kontinuierlich verstellbare Potentiometer handelt sondern um diskontinuierliche Widerstandsketten, was zu Quantisierungssprüngen führt. Diese sind unterschiedlich groß, je nach dem, ob gerade ein Wechsel zwischen benachbarten Abgriffsanschlüssen 21 der grobstufigen Widerstandskette 17 oder ein Wechsel zwischen benachbarten Abgriffsanschlüssen 19 bzw. 33 der beiden feinstufigen Widerstandsketten 15 bzw. 29 stattfindet. Mit Hilfe des Dämpfungsglieds 51 werden von ausgewählten Abgriffsanschlüssen 33 der zweiten feinstufigen Widerstandskette 29 Signalanteile abgenommen und in kombinierter Weise dem vom Abgriffspfeil 35 kommenden Signalwert überlagert, derart, daß die Quantisierungsstufen mindestens weitgehend geglättet werden.

Die in Fig. 3 gezeigte Vorrichtung zur digitalen gehörrichtigen Lautstärkesteuerung wirkt für hohe Frequenzen, für welche der eine Korrekturimpedanz darstellende Kondensator C einen Kurzschluß nach Masse hin darstellt, wie die in Fig. 2 gezeigte Lautstärkesteuerungsvorrichtung ohne Berücksichtigung des Gehörempfindens. In diesem Fall liegt der Ausgang des ersten Puffers 53 wechselspannungsmäßig an Masse. Die grobstufige Widerstandskette 17 führt daher Dämpfungsschritte von 10 dB für das ihr zugeführte fein gedämpfte Audiosignal durch.

Für niederfrequente Signalanteile des zu dämpfenden Audiosignals ist der Kondensator C hochohmig. In diesem Fall wird über den ersten Puffer 53 und die drei Widerstände RL2 bis RL3 ein gedämpftes Audiosignal oder ein Wechselspannungsanteil in die Einspeisungsanschlüsse 55, 57, 59 der grobstufigen Widerstandskette 17 eingespeist. Dies führt zu einer Anhebung des niederfrequenten Signalanteils, d.h. des Baßfrequenzbereichs, und zwar in Abhängigkeit von der Auslegung der feinstufigen Widerstandsketten 15 und 29 und der grobstufigen Widerstandskette 17, die bei dem betrachteten Beispiel Dämpfungsschritte von 1,25 dB bzw. 10 dB bewirken.

Vorzugsweise ist die gesamte in Fig. 3 gezeigte Vorrichtung monolithisch integriert, mit Ausnahme des Kondensators C, der ein externes Bauelement der integrierten Schaltung darstellt.

## Patentansprüche

1. Vorrichtung zur gehörrichtigen Lautstärkesteuerung analoger Audiosignale durch deren Dämpfung,
mit einer Widerstandsteilereinrichtung, die auf einer Seite mit dem zu dämpfenden Audiosignal und auf der anderen Seite mit einem Bezugspotential beaufschlagbar ist und die mit einer Abgriffseinrichtung versehen ist, von der das gedämpfte Audiosignal abnehmbar ist,
wobei die Widerstandsteilereinrichtung mit einer der gehörrichtigen Lautstärkesteuerung dienenden Korrekturimpedanz verbunden ist,
und wobei die Abgriffseinrichtung längs der Widerstandsteilereinrichtung in Abhängigkeit von der gewünschten Lautstärke wählbar auf den Abgriff unterschiedlicher Widerstandswerte steuerbar ist,
dadurch gekennzeichnet,
daß die Widerstandsteilereinrichtung zur digitalen Steuerbarkeit der Vorrichtung mindestens zwei feinstufige Widerstandsketten (15, 29) und eine grobstufige Widerstandskette (17) aufweist, wobei jedem Widerstand je ein Abgriffsanschluß (19, 21, 33) zugeordnet ist,
daß den Abgriffsanschlüssen (19, 21, 33) jeder Widerstandskette (15, 17, 29) eine Abgriffsauswahleinrichtung (25, 27, 35) zugeordnet ist, die mittels eines von der gewünschten Lautstärke abhängenden Abgriffsauswahlsignals steuerbar ist,
daß die beiden feinstufigen Widerstandsketten (15, 29) zu einer Reihenschaltung zusammengeschaltet sind, die einen Endes mit dem zu dämpfenden Audiosignal und anderen Endes mit dem Bezugspotential beaufschlagbar ist,
daß der Verbindungspunkt (31) zwischen den beiden feinstufigen Widerstandsketten (15, 29) die mit der Korrekturimpedanz (C) verbunden ist,
daß die grobstufige Widerstandskette (17) einen Endes mit derjenigen Abgriffsauswahleinrichtung (25) verbunden ist, welche der mit dem zu dämpfenden Audiosingal beaufschlagbaren feinstufigen Widerstandskette (15) zugeordnet ist, und anderen Endes mit dem Bezugspotential beaufschlagbar ist,
daß von der der grobstufigen Widerstandskette (17) zugeordneten Abgriffsauswahleinrichtung (27) das gedämpfte Audiosignal abnehmbar ist
und daß zwischen diejenige Abgriffsauswahleinrichtung (35), welche der mit dem Bezugspotential beaufschlagten feinstufigen Widerstandskette (29) zugeordnet ist, und mindestens einen Einspeisungsanschluß (55, 57, 59) an einer vorbestimmten Stelle längs der grobstufigen Widerstandskette (17) eine Einspeisungseinrichtung (51, 53, RL1, RL2, RL3) zur Einspeisung eines die Gehörempfindungscharakteristik berücksichtigenden Korrektursignals in die grobstufige Widerstandskette (17) geschaltet ist.

2. Vorrichtung nach Anspruch 1, dadurch gekennzeichnet, daß die Korrekturimpedanz einen Kondensator (C) aufweist.

3. Vorrichtung nach Anspruch 1 oder 2, dadurch gekennzeichnet, daß die beiden feinstufigen Widerstandsketten (15, 29) identisch aufgebaut sind.

4. Vorrichtung nach einem der Ansprüche 1 bis 3, dadurch gekennzeichnet, daß die Abgriffsauswahleineinrichtungen (25, 35) der beiden feinstufigen Widerstandsketten (15, 29) von demselben Abgriffsauswahlsignal gesteuert werden, derart, daß diese beiden Abgriffsauswahleinrichtungen (25, 35) immer gleichzeitig gleichwertige Abgriffsanschlüsse (19, 33) der beiden feinstufigen Widerstandsketten (15, 29) auswählen.

5. Vorrichtung nach einem der Ansprüche 1 bis 4, dadurch gekennzeichnet, daß jede Abgriffsauswahleinrichtung (25, 27, 35) eine der Anzahl der Abgriffsanschlüsse entsprechende Zahl von steuerbaren elektronischen Schaltern aufweist, die eingangsseitig mit je einem zugeordneten Abgriffsanschluß (19, 33) verbunden und ausgangsseitig alle zusammengeschaltet sind und von denen in Abhängigkeit vom jeweiligen Abgriffsauswahlsignal jeweils einer leitend geschaltet wird.

6. Vorrichtung nach einem der Ansprüche 1 bis 5, dadurch gekennzeichnet, daß eine Schieberegistereinrichtung vorgesehen ist, in der ein der jeweils gewünschten Lautstärke entsprechendes Codesignal gespeichert ist, und daß eine Decodiereinrichtung (47, 49) vorgesehen ist, die aus dem gespeicherten Codesignal das Abgriffsauswahlsignal für die Abgriffsauswahleinrichtung (25, 27, 35) einer jeden Widerstandskette (15, 17, 29) erstellt.

7. Vorrichtung nach einem der Ansprüche 1 bis 6, dadurch gekennzeichnet, daß die Einspeisungseinrichtung (51, 53, RL1, RL2, RL3) mehrere Ausgangsanschlüsse aufweist, die je mit einem von mehreren Einspeisungsanschlüssen (55, 57, 59) verbunden sind, die an vorbestimmten unterschiedlichen Stellen längs der grobstufigen Widerstandskette (17) angeordnet sind.

8. Vorrichtung nach einem der Ansprüche 1 bis 7, dadurch gekennzeichnet, daß die Einspeisungseinrichtung (51, 53, RL1, RL2, RL3) eine steuerbare Glättungseinrichtung (51) aufweist, die eine mindestens teilweise Glättung der von den Widerstandsketten (15, 17, 29) bedingten Quantisierungsstufen im gedämpften Audiosignal bewirkt.

9. Vorrichtung nach Anspruch 8, dadurch gekennzeichnet, daß die Glättungseinrichtung (51) das Ausgangssignal der Auswahleinrichtung (35), die der mit dem Bezugspotential beaufschlagten feinstufigen Widerstandskette (29) zugeordnet ist, mit einem steuerbaren Glättungssignal versieht.

10. Vorrichtung nach Anspruch 9, dadurch gekennzeichnet, daß das Glättungssignal in steuerbarer Auswahl von vorbestimmten Abgriffsanschlüssen (33) der mit dem Bezugspotential beaufschlagbaren Widerstandskette (29) abnehmbar ist.

## Claims

1. A device for aurally compensated loudness control of analog audio signals by attenuation thereof, comprising
a resistance divider means adapted to be acted upon on the one side by the audio signal to be attenuated and on the other side by a reference potential and being provided with a tapping means from which the attenuated audio signal can be taken off,
the resistance divider means being connected to a correction impedance serving for aurally compensated loudness control,
and the tapping means being controllable along the resistance divider means in selective manner with respect to the tapping of different resistance values, as a function of the desired loudness,
characterized in
that the resistance divider means comprises for digital controllability of the device at least two fine-stepped resistor chains (15, 29) and one coarse-stepped resistor chain (17), with each resistor having one tap terminal (19, 21, 33) associated therewith,
that the tap terminals (19, 21, 33) of each resistor chain (15, 17, 29) have a tap selector means (25, 27, 35) associated therewith that is controllable by means of a tap selection signal depending on the desired loudness,
that the two fine-stepped resistor chains (15, 29) are interconnected so as to form a series connection adapted to be acted upon on one end by the audio signal to be attenuated and on the other end by the reference potential,
that the connection point (31) between the two fine-stepped resistor chains (15, 29) is connected to the correction impedance (C),
that the coarse-stepped resistor chain (17) has one end connected to that tap selector means (25) that is associated with the fine-stepped resistor chain (15) adapted to be acted upon by the audio signal to be attenuated, and on the other end is adapted to be acted upon by the reference potential,
that the attenuated audio signal can be taken off from the tap selector means (27) associated with the coarse-stepped resistor chain (17),
and in that a feed-in means (51, 53, RL1, RL2, RL3) for feeding a correction signal into the coarse-stepped resistor chain (17), which takes the aural sensation characteristics into consideration, is connected between that tap selector means (35) that is associated with the fine-stepped resistor chain (29) acted upon by the reference potential, and at least one feed-in terminal (55, 57, 59) at a predetermined location along the coarse-stepped resistor chain (17).

2. A device according to claim 1,
characterized in that the correction impedance comprises a capacitor (C).

3. A device according to claim 1 or 2,
characterized in that the two fine-stepped resistor chains (15, 29) are of identical construction.

4. A device according to any one of claims 1 to 3,
characterized in that tap selector means (25, 35) of the two fine-stepped resistor chains (15, 29) are controlled by the same tap selection signal, such that these two tap selector means (25, 35) always select simultaneously equivalent tap terminals (19, 33) of the two fine-stepped resistor chains (15, 29).

5. A device according to any one of claims 1 to 4,
characterized in that each tap selector means (25, 27, 35) comprises a number of controllable electronic switches corresponding in number to the tap terminals and being connected on the input side to one associated tap terminal (19, 33) each and being all interconnected on the output side, with a respective one of said switches being switched into the conductive state as a function of the respective tap selector signal.

6. A device according to any one of claims 1 to 5,
characterized in that a shift register means is provided having stored therein a code signal corresponding to the particular loudness desired, and in that a decoder means (47, 49) is provided generating from the stored code signal the tap selector signal for the tap selector means (25, 27, 35) of each resistor chain (15, 17, 29).

7. A device according to any one of claims 1 to 6,
characterized in that the feed-in means (51, 53, RL1, RL2, RL3) comprises several output terminals each connected to one of a plurality of feed-in terminals (55, 57, 59) arranged at predetermined different locations along the coarse-stepped resistor chain (17).

8. A device according to any one of claims 1 to 7,
characterized in that the feed-in means (51, 53, RL1, RL2, RL3) comprises a controllable smoothing means (51) effecting at least partial smoothing of the quantization steps in the attenuated audio signal caused by the resistor chains (15, 17, 29).

9. A device according to claim 8,
characterized in that the smoothing means (51) applies a controllable smoothing signal to the output signal of the selector means (35) associated with the fine-stepped resistor chain (29) acted upon by the reference potential.

10. A device according to claim 9,
characterized in that the smoothing signal can be taken off in controllable selection of predetermined tap terminals (33) of the resistor chain (29) adapted to be acted upon by the reference potential.

## Revendications

1. Dispositif de correction physiologique de signaux audio analogiques par atténuation,
comportant un pont diviseur résistif qui est alimenté d'un côté par le signal audio à atténuer et de l'autre côté par un potentiel de référence et qui est muni d'un curseur sur lequel est prélevé le signal audio atténué,
le pont diviseur résistif étant relié à une impédance de correction destinée à effectuer la correction physiologique, et
le curseur étant réglable le long du pont diviseur résistif selon le volume souhaité par le choix de prélèvements au niveau de différentes valeurs de résistance,
caractérisé en ce que
le pont diviseur résistif, afin de pouvoir commander le dispositif de manière numérique, comprend au moins deux chaînes de résistances (15, 29) de réglage fin et une chaîne de résistances (17) de réglage grossier, chaque résistance étant associée à une borne de prélèvement (19, 21, 33),
les bornes de prélèvement (19, 21, 33) de chaque chaîne de résistances (15, 17, 29) sont associées à un curseur (25, 27, 35) qui est susceptible d'être commandé par un signal de sélection dépendant du volume souhaité,
les deux chaînes de résistances de réglage fin (15, 29) sont disposées dans une connexion série qui reçoit par un côté le signal audio à atténuer et par l'autre côté le potentiel de référence,
le point de liaison (31) entre les deux chaînes de résistances de réglage fin (15, 29) est relié à l'impédance de correction (C),
la chaîne de résistances de réglage grossier (17) est reliée par un côté au curseur (25) qui est associé à la chaîne de résistances de réglage fin (15) recevant le signal audio à atténuer, et par l'autre côté au potentiel de référence,
le signal audio atténué est prélevé sur le curseur (27) associé à la chaîne de résistances de réglage grossier (17), et
un dispositif d'alimentation (51, 53, RL1, RL2, RL3) pour fournir à la chaîne de résistances de réglage grossier (17) un signal de correction correspondant à la caractéristique de sensibilité de l'oreille est connecté entre le curseur (35) qui est associé à la chaîne de résistances de réglage fin (29) recevant le potentiel de référence et au moins une borne d'alimentation (55, 57, 59) à une position prédéterminée dans la chaîne de résistances de réglage grossier (17).

2. Dispositif selon la revendication 1, caractérisé en ce que l'impédance de correction comprend un condensateur (C).

3. Dispositif selon la revendication 1 ou 2, caractérisé en ce que les deux chaînes de résistances de réglage fin (15, 29) sont de même constitution.

4. Dispositif selon l'une des revendications 1 à 3, caractérisé en ce que les curseurs (25, 35) des deux chaînes de résistances de réglage fin (15, 29) sont commandés par le même signal de sélection, de manière que ces deux curseurs (25, 35) sélectionnent en même temps des bornes de prélèvement (19, 33) associées à une même valeur des deux chaînes de résistances de réglage fin (15, 29).

5. Dispositif selon l'une des revendications 1 à 4, caractérisé en ce que chaque curseur (25, 27, 35) comprend un nombre d'interrupteurs électroniques correspondant au nombre de bornes de prélèvement, les interrupteurs électroniques étant reliés tous ensemble du côté de la sortie et, du côté de l'entrée, à des bornes de prélèvement associées (19, 33), un seul interrupteur à la fois étant fermé en fonction du signal de sélection correspondant.

6. Dispositif selon l'une des revendications 1 à 5, caractérisé en ce qu'il comprend un registre à décalage dans lequel est stocké un code correspondant au volume souhaité, et un dispositif de décodage (47, 49) qui établit, à partir du code stocké, le signal de sélection pour le curseur (25, 27, 35) de chacune des chaînes de résistances (15, 17, 29).

7. Dispositif selon l'une des revendications 1 à 6, caractérisé en ce que le dispositif d'alimentation (51, 53, RL1, RL2, RL3) comporte plusieurs bornes de sortie dont chacune est reliée à l'une de plusieurs bornes d'alimentation (55, 57, 59) qui sont disposées à des positions prédéterminées différentes dans la chaîne de résistances de réglage grossier (17).

8. Dispositif selon l'une des revendications 1 à 7, caractérisé en ce que le dispositif d'alimentation (51, 53, RL1, RL2, RL3) comprend un dispositif de lissage (51) qui réalise un lissage au moins partiel, dans le signal audio atténué, des échelons de quantification provoqués par les chaînes de résistances (15, 17, 29).

9. Dispositif selon la revendication 8, caractérisé en ce que le dispositif de lissage (51) fournit un signal de lissage commandé au signal de sortie du curseur (35) qui est associé à la chaîne de résistances de réglage fin (29) reliée au potentiel de référence.

10. Dispositif selon la revendication 9, caractérisé en ce que le signal de lissage est prélevé sélectivement sur des bornes de prélèvement prédéterminées (33) de la chaîne de résistances (29) reliée au potentiel de référence.
